# EUROPEAN PATENT APPLICATION

(11) **EP 1 761 117 A1**
(43) Date of publication of application: **07.03.2007**
(21) Application number: 06018327.4
(22) Date of filing: 01.09.2006
(51) Int. Cl.: H05K 1/18, H01L 23/64, H01G 2/06

(54) **Wiring board with embedded ceramic capacitors**

(30) Priority: 01.09.2005 JP 2005254029; 20.07.2006 JP 2006198796
(71) Applicant: NGK SPARK PLUG CO., LTD, Mizuho Nagoya Aichi (JP)
(72) Inventor: Urashima, Kazuhiro, Kounan city Aichi (JP); Yuri, Shinji, Kasugai city Aichi (JP); Sato, Manabu, Nagoya city Aichi (JP); Otsuka, Jun, Konan-shi Aichi 483-8148 (JP)
(74) Representative: Zimmermann & Partner

(57) **Abstract**

A wiring board is provided, which is capable of bringing out the advantages of the structure where a plurality of semiconductor integrated circuit elements are mounted, and the wiring board which allows a reduction in size thereof and offers excellent cost performance and reliability.

A wiring board 10 according to the present invention includes a substrate core 11, a ceramic capacitor 100, 101 and a built-up layer 31. The substrate core 11 has a housing opening portion 91 therein which opens at a core main surface 12. The ceramic capacitor 100, 101 is accommodated in the housing opening portion 91 in the state where the core main surface 12 and a capacitor main surface 102 are turned to the same side. The built-up layer 31 includes a semiconductor integrated circuit element mounting area 23, 24 in various locations on a surface 39 thereof. In the substrate core 11, each ceramic capacitor 100, 101 is disposed in an area corresponding to each semiconductor integrated circuit element mounting area 23, 24, respectively.

## Description

The present invention is related to a wiring board having a structure wherein a ceramic capacitor is embedded in a substrate core and a built-up layer is laminated on a surface of the substrate core on which a semiconductor integrated circuit element is mounted.

In recent years, the semiconductor integrated circuit element (IC chip) used for CPU in a computer etc. has operated at higher speeds with high functioning features. Along with this advance, the number of terminals increases and the terminal interval tends to be narrow. Generally, many terminals are densely formed on the bottom surface of the IC chip in an array form, and such a terminal block is connected to a terminal block at the motherboard side by flip chip connection. However, since the pitch between the terminal block at the IC chip side and the terminal block at the motherboard side has a great difference, it is difficult to directly connect the IC chip to the motherboard. Therefore, the connection method generally employed is such that a package constituted by the IC chip, which is mounted on a wiring board for mounting the IC chip, is produced and then mounted on the mother board. An example of such wiring boards for mounting the IC chip, which constitutes this type of package, includes a wiring board where a ceramic chip is embedded in a core substrate, which is comprised of a polymer material, so as to form a core portion, and a built-up layer is formed on both top and rear surfaces of the core portion, respectively (e.g., see Japanese Patent Application Laid-Open (kokai) No. 2005-39243).

Recently, the strong demand for a system capable of offering a higher performance than a package where only a single microprocessor is mounted has been increasing. One of the examples for such system includes a package having a plurality of microprocessors. That is, this type of package having such multi-microprocessor structure is capable of performing a parallel processing of plural threads (tasks), which a single microprocessor structure or the like cannot perform, resulting in improving the processing capacity of the entire system. Further, a failure-resistance of the multi-microprocessor structure is improved compared to the single microprocessor structure.

When carrying out a package having a multi-microprocessor structure, fore xample, aceramic capacitor in a wiring board according to Japanese Patent Application Laid-Open (kokai) No. 2005-39243 is enlarged, and a microprocessor is mounted on plural locations, respectively, within an accommodation area of the enlarged ceramic capacitor. However, when this structure is adopted, an area in a substrate core for forming a conductor portion, such as a through-hole and a conductive pattern, will decrease. Thus, a wiring for the conductor portion for used in electrically connecting the top and rear surfaces of a core portion becomes difficult, thereby being unlikely to reduce in the overall size of the wiring board.

Further, the wiring board according to Japanese Patent Application Laid-Open (kokai) No.2005-39243canbeusedasacomponent part of a package having the multi-microprocessor structure when a plurality of power supply systems of the microprocessors can be shared. However, when the power supply system cannot be shared, and it is necessary to establish the power supply system for every microprocessor, each microprocessor can not be fully operated, even though the wiring board is used as a component part. Therefore, the advantages of multi-microprocessor structure cannot be fully realized.

In this type of package, since the calorific power of the microprocessor also increases, it is very important to match the coefficient of thermal expansion between the microprocessor and the wiring board. That is, when the thermal expansion coefficient between the microprocessor and the wiring board does not match, substantial heat stress will be imposed on a microprocessor, and a crack and a faulty connection tends to occur in the microprocessor. Therefore, it is necessary to adopt the structure which can reduce the influence of such heat stress.

The present invention has been accomplished in view of the above problems, and an object of the invention is to provide a wiring board capable of bringing out the advantages of the structure where a plurality of semiconductor integrated circuit elements are mounted, and the wiring board which allows a reduction in size thereof and offers excellent cost performance and reliability.

In light of the above, the present invention provides the wiring board according to independent claim 1.

Further advantages, features, aspects and details of the invention are evident from the dependent claims, the description and the drawings.

A means for solving the above-mentioned problem is a wiring board, comprising: a substrate core including a core main surface and a core rear surface; a plurality of ceramic capacitors having a capacitor main sur face and a structure where a first inner electrode layer and a second inner electrode layer are alternately laminated by sandwiching a ceramic dielectric layer, wherein said ceramic capacitor is embedded in said substrate core in the state where said core main surface and said capacitor main surface are turned to the same side; and a built-up layer having a structure where an inter layer insulating layer and a conductor layer are alternately laminated on said core main surface and said capacitor main surface, and including a plurality of semiconductor integrated circuit element mounting areas in various locations on a surface of said built-up layer, and wherein said plural ceramic capacitors are disposed in areas of said substrate core, which correspond to said plural semiconductor integrated circuit element mounting areas.

Therefore, according to the wiring board of the above described means, a plurality of semiconductor integrated circuit element mounting areas on which a semiconductor integrated circuit element may be mounted is provided in the built-uplayer, and, in the substrate core, a plurality of ceramic capacitors are disposed in the areas corresponding to a plurality of semiconductor integrated circuit element mounting areas, respectively. Therefore, a conductor portion, such as a through-hole conductor or a conductor pattern or the like can be formed in an area formed between the adjoining ceramic capacitors. As a result, even though it is a case where the structure of mounting a plurality of semiconductor integrated circuit elements is adopted, a conductor layer can be formed for establishing an electrical connection between the top and rear surfaces of the substrate core, resulting in a prevention of an enlargement of the overall size of the wiring board.

Further, even if a power supply system of plural semiconductor integrated circuit elements cannot be shared and an individual power supply system for each semiconductor integrated circuit element is necessary, each semiconductor integrated circuit element can fully operate because the plural ceramic capacitors are electrically connected to the semiconductor integrated circuit element mounting areas, respectively. Therefore, when adopting the structure of mounting a plurality of semiconductor integrated circuit elements, the advantages of such a structure can be fully realized.

Furthermore, according to this structure, each semiconductor integrated circuit element is supported on each ceramic capacitor. Thus, compared to the conventional structure where each semiconductor integrated circuit element is supported on a single large ceramic capacitor, the influence of heat stress is reduced because a thermal expansion coefficient with the semiconductor integrated circuit element can easily match. Therefore, a crack and a faulty connection of the semiconductor integrated circuit element due to great heat stress can be prevented.

As mentioned above, in the substrate core, a plurality of ceramic capacitors are disposed in the areas corresponding to a plurality of semiconductor integrated circuit element mounting areas, respectively. The terms "the areas corresponding to a plurality of semiconductor integrated circuit element mounting areas" here means an inner area present and corresponding to a plurality of semiconductor integrated circuit element mounting areas. Speaking more concretely, each ceramic capacitor is disposed, respectively, in the inner area of the substrate core which is situated generally directly below the plural semiconductor integrated circuit element mounting area. Each ceramic capacitor disposed in this way is provided so that a part of or the entire ceramic capacitor may overlap the semiconductor integrated circuit element mounting area, when looking from the thickness direction of the capacitor. In addition, correlation in the magnitude between the dimension of each ceramic capacitor when looking from the thickness direction of the capacitor and the dimension of each semiconductor integrated circuit element mounting area can be at one's discretion. However, it is preferable that the former dimension be equal to or lager than the latter dimension.

Here, "semiconductor integrated circuit element" in the present invention means mainly a semiconductor integrated circuit element used as a microprocessor or the like of a computer. The semiconductor integrated circuit element is, for example, flip chip connected to the semiconductor integrated circuit element mounting area. Notably, "semiconductor integrated circuit element mounting area" means an area where a terminal pad block is disposed on the surface of the built-up layer. Two or more semiconductor integrated circuit elements mounting areas (i.e., the number of semiconductor integrated circuit element) may be provided.

The substrate core constituting the above-mentioned wiring board is a part of the core portion in the wiring board, and assumes, for example, a plate-like form or shape having the core main surface and the core rear surface located opposed to the core main surface. The substrate core may include one ormore housing opening portion (s) for accommodating the ceramic capacitor. The housing opening portion may be a non-through-hole which only opens at the core main surface, or may be a through-hole which opens at both core main surface and core rear surface.

Although the material for forming the substrate core is not limited, a preferable substrate core is comprised mainly of a polymer material. Examples of the polymer materials for forming the substrate core include EP resin (epoxyresin), PI resin (polyimide resin), BT resin (bismaleimide triazine resin), PPE resin (polyphenylene ether resin), etc. Notably, a composite material made of these resins and organic fibers, such as glass fiber (glass woven fabric and non-woven glass fabric) or polyamide fiber may be employed.

The ceramic capacitor constituting the above-mentioned wiring board has the capacitor main surface and a structure where the first inner electrode layer and the second inner electrode layer are alternately laminated by sandwiching the ceramic dielectric layer. Preferably, the ceramic capacitor includes a capacitor main surface and a capacitor rear surface, which is located opposite side of the capacitor main surface. The ceramic capacitor in the present invention includes a capacitor formed in such a manner that a thin film layer made of ceramic material is laminated on a substrate (not limited to ceramic substrate). The ceramic capacitor is embedded in the substrate core in the state where the core main surface and the capacitor main surface are turned to the same side. The terms "embedded" here means the state where at least a part of a ceramic capacitor is accommodated in the housing opening portion of the substrate core or the state where the entire ceramic capacitor is accommodated in the housing opening portion of the substrate core. Further, the ceramic capacitor is fixed by a filler made from, for example, a polymer material in the state that the ceramic capacitor is embedded in the substrate core.

Although two or more ceramic capacitors may be provided, the same number as the number of semiconductor integrated circuit element mounting areas is preferable. Constituting this way, all the ceramic capacitors can be electrically connected to all semiconductor integrated circuit element mounting areas. Further, a suitable example of the ceramic capacitor includes a via arrayed type ceramic capacitor. Namely, the ceramic capacitor includes a plurality of via conductors for the power supply which electrically connect the said first inner electrode layers, and a plurality of via conductors for the ground which electrically connect the second inner electrode layers. The plural via conductors for the power supply and the plural via conductors for the ground are preferably disposed in an array form as a whole. That is, the plural via conductors for the power supply and the plural via conductors for the ground together are preferably disposed as an array. When employing this structure, a reduction in size of the ceramic capacitor is facilitated, thereby facilitating a reduction in the overall size of the wiring board. Furthermore, despite its compact size, high electric capacity may be relatively easily secured, resulting in establishing more stable power supply.

Notably, when the substrate core has a plurality of housing opening portions therein which open at the core main surface, the ceramic capacitor is preferably accommodated in each housing opening portion in the state where the core main surface and the capacitor main surface are turned to the same side. With this structure, it is easy to secure the area for forming the conductor portion such as a through-hole conductor or a conductor pattern in the area formed between the adjoining housing opening portions. As a result, even though the structure of mounting plural semiconductor integrated circuit elements is adopted, a wiring of the conductor layer used for electrically connecting the top and rear surfaces of the substrate core becomes easy. That is, the substrate core may include the conductor portion, which is used for electrically connecting the core main surface and the core rear surface, in the area formed between the adjoining housing opening portions.

On the other hand, when the substrate core includes only a single housing opening portion therein, which opens at the core main surface, the plural ceramic capacitors are preferably accommodated in the housing opening portion in the state where the core main surface and the capacitor main surface are turned to the same side. With this structure, the formation of the substrate core becomes easy be cause the same number of housing opening portions as that of the ceramic capacitor is not necessarily formed when all the ceramic capacitors are to be accommodated, resulting in easy formation of the wiring board. Notably, the substrate core may include the conductor portion, which is used for electrically connecting the core main surface and the core rear surface, in the area formed between the adjoining ceramic capacitors. In this case, the area formed between the adjoining ceramic capacitors is filled by the filler, and the conductor portion, such as a through-hole conductor or a conductor pattern is formed in the filler. The filler preferably comprises a resin material having an insulating characteristic.

The aforementioned conductor portion, such as a through-hole conductor or a conductive pattern is preferably electrically connected to, for example, the conductor layer for signals in the wiring board. In this case, design flexibility for wiring can be improved. Alternately, the conductor portion such as a through-hole conductor or a conductive pattern is preferably electrically connected to, for example, the conductor layer for the ground. According to this structure, because the shielding effectiveness can be obtained, an interference arising between the ceramic capacitors can be prevented, and a noise caused by the interference can be reduced. When the conductor portion is the through-hole conductor, the plural through-hole conductors are preferably disposed in rows so that higher shielding effectiveness may be attained. In addition, the conductor portion can be a dummy conductor layer, which is electrically connected to neither the conductor layers for signals, for the power supply nor for the ground.

A sintered body of high-temperature-firing ceramics, such as alumina, aluminum nitride, boron nitride, silicon carbide and silicon nitride, is preferably employed as a ceramic dielectric layer. Also, a sintered body of low-temperature-firing ceramics, such as a glass-ceramic formed in such a manner that inorganic ceramic fillers, such as alumina, is added to borosilicic acid system glass or lead borosilicate system glass is preferably employed as a ceramic dielectric layer. In this case, it is also preferable to employ a sintered body of dielectric ceramics, such as barium titanate, lead titanate and strontium titanate, according to a use. When the sintered body of dielectric ceramics is employed, a ceramic capacitor with a large electrostatic capacitance can be expected.

The material for forming the first inner electrode layer and the second inner electrode layer is not particularly limited, however, a metal which can be sintered simultaneously with ceramics, for example, nickel, molybdenum, tungsten, titanium or the like is suitable. In addition, when the sintered body of low-temperature-firing ceramics is adopted, copper, silver or the like can be employed as a material for forming the first inner electrode layer and the second inner electrode layer.

The ceramic capacitor may include a resistive element which comprises a material having a higher resistance value than the material constituting the first inner electrode layer and said second inner electrode layer. With this structure, for example, various potential can be established within the same ceramic capacitor, thereby facilitating advanced features of the wiring board. When no resistive element is formed in the ceramic capacitor, the resistive element must be provided in a separate location from the ceramic capacitor in the substrate core, or provided at the built-up layer side, resulting in it being hard to form the resistive element. In addition, a material for forming the resistive element may be a conductive material having a higher resistance value than that of the first inner electrode layer and the second inner electrode layer. The examples of such material include a metal material, ceramic material or the like.

The built-up layer constituting the wiring board has a structure where an interlayer insulating layer, which comprised mainlyofapolymermaterial, and the conductor layer are alternately laminated. Although the-built-up layer (first built-up layer) may be formed only on the core main surface and the capacitor main surface, a second built-up layer having a structure where the interlayer insulating layer and the conductor layer are alternately laminated may be formed on the core rear surface and the capacitor rear surface. With this structure, an electric circuit can be formed not only in the first built-up layer but also in the second built-up layer, thereby facilitating much more advanced features of the wiring board.

Notably, the built-up layer (first built-up layer) formed on the core main surface and the capacitor main surface includes a plurality of semiconductor integrated circuit element mounting areas in various locations of the surface of the built-up layer. Since a semiconductor element can be mounted on such semiconductor integrated circuit element mounting area, the difference in thermal expansion coefficient with the semiconductor integrated circuit element can be reduced, compared with the case where the semiconductor integrated circuit element mounting area is formed on the substrate core. Thus, this structure facilitates a reduction in the influence of the thermal stress imposed on the semiconductor integrated circuit element.

In addition, the dimension of the semiconductor integrated circuit element mounting area is established so as to be equal to or smaller than the dimension of the capacitor main surface of the corresponding ceramic capacitor. The semiconductor integrated circuit element mounting area is preferably located within the capacitor main surface of the corresponding ceramic capacitor, when looking from the thickness direction of the ceramic capacitor. With this structure, since the semiconductor integrated circuit element mounting area is located in the area right above the ceramic capacitor,thesemiconductorintegrated circuitelement mounted on the semiconductor integrated circuit element mounting area is supported by the ceramic capacitor having high rigidity and a small coefficient of thermal expansion. Therefore, in the semiconductor integrated circuit element mounting area, the built-up layer is unlikely to deform, thereby being able to stably support the semiconductor integrated circuit element mounted on the semiconductor integrated circuit element mounting area. As described above, the dimension of the semiconductor integrated circuit element mounting area is smaller than that of capacitor main surface of the corresponding ceramic capacitor. Preferably, the dimension of the semiconductor integrated circuit element mounting area is, in detail, 90% or less of the dimension of the capacitor main surface, the most preferably, 50% or more to 90% orless. When the dimension of the semiconductor integratedcircui t element mounting area is 90% or less, the semiconductor integrated circuit element can be easily and stably supported. Further, when the dimension of the semiconductor integrated circuit element mounting area is 50% or more, the dimension of the semiconductor integrated circuit element mounting area will not be too small.

According to another aspect, a wiring board is provided, which is capable of fully bringing out the advantages of the structure where a plurality of semiconductor integrated circuit elements are mounted, and the wiring board which allows a reduction in size thereof and offers excellent cost performance and reliability.

The wiring board includes a substrate core, a ceramic capacitor and a built-up layer. The substrate core has a housing opening portion therein which opens at a core main surface. The ceramic capacitor is accommodated in the housing opening portion in the state where the core main surface and a capacitor main surface are turned to the same side. The built-up layer includes a semiconductor integrated circuit element mounting area in various locations on a surface thereof. In the substrate core, each ceramic capacitor is disposed in an area corresponding to each semiconductor integrated circuit element mounting area, respectively.

Embodiments according to the invention are also directed to methods by which the described apparatus is manufactured. It includes method steps for carrying out every function of the apparatus or manufacturing every part of the apparatus.

The invention will be better understood by reference to the following description of embodiments of the invention taken in conjunction with the accompanying drawings, wherein:
Fig. 1 is a schematic sectional view showing a wiring board according to a first embodiment for carrying out the present invention.
Fig. 2 is a schematic sectional view showing a ceramic capacitor.
Fig. 3 is a schematic explanatory view showing the connection in an inner layer of a ceramic capacitor.
Fig. 4 is a schematic explanatory view showing the connection in an inner layer of a ceramic capacitor.
Fig. 5 is an explanatory view showing a manufacturing method of a wiring board.
Fig. 6 is an explanatory view showing a manufacturing method of a wiring board.
Fig. 7 is an explanatory view showing a manufacturing method of a wiring board.
Fig. 8 is a schematic sectional view showing a ceramic capacitor according to a second embodiment.
Fig. 9 is a schematic sectional view showing a ceramic capacitor according to another embodiment.
Fig. 10 is a schematic plan view of a ceramic capacitor showing a vicinity of resistive element according to another embodiment.
Fig. 11 is a schematic sectional view of a ceramic capacitor showing a vicinity of resistive element.
Fig. 12 is a schematic sectional view of a ceramic capacitor showing a vicinity of resistive element.
Fig. 13 is a schematic sectional view showing a wiring board according to another embodiment.
Fig. 14 is a schematic plan view of a ceramic capacitor showing a vicinity of capacitor portion according to another embodiment.

Hereafter, a first embodiment for carrying out a wiring board of the present invention will be described in detail with reference to the drawings.

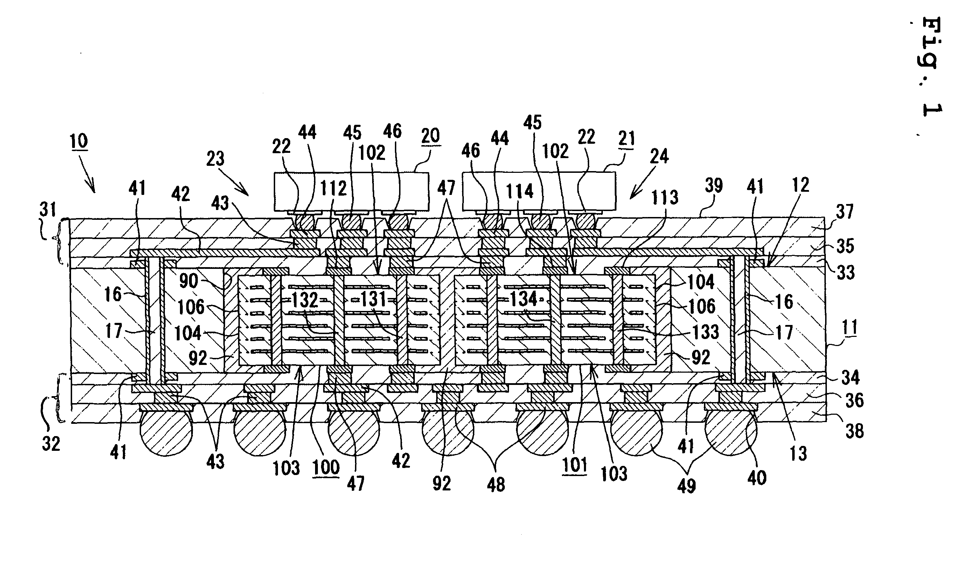

As shown in Fig. 1, a wiring board 10 according to the present embodiment is a wiring board for mounting an IC chip, and comprising: a substrate core 11 comprised of glass epoxy and assuming a generally rectangular form; a first built-up layer 31 (built-up layer) formed on an upper surface 12 (core main surface) of the substrate core 11; and a second built-up layer 32 formed on an lower surface 13 (core rear surface) of the substrate core 11. A through-hole conductor 16 is formed in plural locations in the substrate core 11. The through-hole conductor 16 electrically connects between the upper surface 12 side and the lower surface 13 side of the substrate core 11. Inaddition,insideofthethrough-holeconductor 16 is filled with, for example, a plugging body 17, such as epoxy resin. Moreover, a conductor layer 41 comprised of copper is formed in a pattern on the upper surface 12 and the lower surface 13 of the substrate core 11 so that each conductor layer 41 may be electrically connected to the through-hole conductor 16.

The first built-up layer 31 formed on the upper surface 12 of the substrate core 11 has a structure where resin insulating layers 33, 35 (hereinafter referred to as an interlayer insulating layer) comprised of epoxy resin and a conductor layer 42 comprised of copper are alternately laminated. In this embodiment, a thermal expansion coefficient of the first built-up layer 31 is about 30-40 ppm/°C, indetail, about 35 ppm/°C. The thermal expansion coefficient of the first built-up layer 31 is defined as an average value of the measured value at between 30°C and a glass-transition temperature (Tg). A part of the conductor layer 42 formed on the surface of the resin insulating layer 33 serving as a first layer is electrically connected to an upper end of the through-hole conductor 16. Terminal pads 44 are formed in plural locations on the surface of the second resin insulating layer 35 in an array form. Moreover, the surface of the resin insulating layer 35 is almost entirely covered with a solder resist 37. Openings 46 to which the terminal pads 44 are exposed are formed in the predetermined locations of the solder resist 37. Plural solder bumps 45 are disposed on the surfaces of the terminal pads 44, respectively. Each solder bump 45 is electrically connected to planar connection terminals 22 of IC chips 21, 22 (semiconductor integrated circuit element), respectively. The IC chips 20, 21 according to the present embodiment assume a rectangular plate-like form or shape and are comprised of silicon having a thermal expansion coefficient of about 3.5 ppm/°C. In addition, in the first built-up layer 31, each terminal pad 44 and each solder bump 45 are located within an area right above a ceramic capacitor 100, 101, respectively. This area serves as an IC chip mounting area 23, 24 (a semiconductor integrated circuit element mounting area). The IC chip mounting area 23, 24 is formed in two separate locations on a top surface 39 of the first built-up layer 31. Moreover, the resin insulating layers 33, 35 include via conductors 43, 47, respectively. Most of these via conductors 43, 47 are disposed on the same axle, and the conductor layers 41, 42 and the terminal pad 44 are electrically connected through these conductors.

As shown in Fig. 1, the second built-up layer 32 formed on the lower surface 13 of the substrate core 11 has the almost same structure as that of the first built-up layer 31. That is, the second built-up layer 32 has a thermal expansion coefficient of about 30-40 ppm/°C and has a structure where resin insulating layers 34, 36 (hereinafter referred to as an interlayer insulating layer) comprised of epoxy resin and a conductor layer 42 are alternately laminated. Apart of conductor layer 42 formed on the lower surface of the resin insulating layer 34 serving as the first layer is electrically connected to the lower end of the through-hole conductor 16. BGA pad 48 electrically connected to the conductor layer 42 through the via conductor 43 is formed in plural locations on the lower surface of the second resin insulating layer 36 with a lattice pattern. Moreover, the lower surface of the resin insulating layer 36 is almost entirely covered with a solder resist 38. Openings 40 to which the BGApads 48 are exposed are formed in the predetermined locations of the solder resist 38. Plural solder bumps 49 for electrically connecting to a motherboard (not illustrated) are disposed on the surfaces of the BGA pads 48, respectively. Then, the wiring board 10 is mounted on the motherboard (not illustrated) through each solder bump 49.

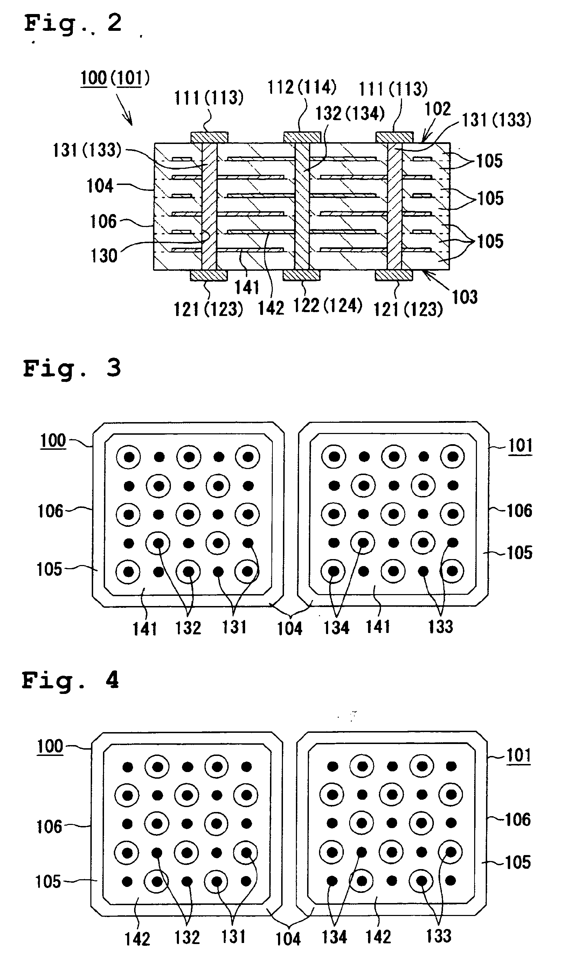

The thermal expansion coefficient of the substrate core 11 is about 10-15 ppm/°C in the planar direction (XY direction). In addition, the thermal expansion coefficient of the substrate core 11 is defined as the average value of the measured value at between 30 °C and a glass-transition temperature (Tg). The substrate core 11 has a rectangular-shaped housing opening portion 90 in a plane view which opens at each center portion of the upper surface 12 and the lower surface 13. That is, the housing opening portion 90 is a through-hole portion. A ceramic capacitor 100, 101 as shown in Figs. 2 to 4 or the like are accommodated in the housing opening portion 90 so as to be embedded therein. In addition, the ceramic capacitor 100, 101 are accommodated next to each other in the sate where the upper surface 102 (capacitor main surface) is turned to the same side as the upper surface 12 of the substrate core 11. The ceramic capacitor 100, 101 according to the present embodiment assumes the rectangular plate-like form or shape with the size of 12.0 mm (vertical) x12.0mm (lateral) x 0.8mm (thickness). In addition, the thickness of the ceramic capacitor 100, 101 is preferably 0.2mm or more to 1.0mm or less. When the thickness of the ceramic capacitor is less than 0.2mm, the ceramic capacitor 100, 101 is unable to reduce the stress arisen from at the time of mounting the IC chip 20, 21 on the IC chip mounting area 23, 24, thereby not sufficiently functioning as a support. On the other hand, when the thickness of the ceramic capacitor is larger than 1.0mm, the wiring board 10 will become thick. More preferably, the thickness of the ceramic capacitor 100, 101 is 0.4 mm or more to 0.8 mm or less. In substrate core 11, the ceramic capacitor 100 is disposed in the area right under the IC chip mounting area 23, and the ceramic capacitor 101 is disposed in the area right below the IC chip mounting area 24. The dimension of the IC chip mounting area 23 (the face area where the planar connection terminals 22 of the IC chip 20 are formed) is smaller than the upper surface area 102 of the corresponding ceramic capacitor 100. Similarly, the dimension of the IC chip mounting area 24 (the face area where the planar connection terminals 22 of the IC chip 21 are formed) is also smaller than the area of the upper surface 102 of the corresponding ceramic capacitor 101. When looking from the thickness direction of the ceramic capacitor 100, 101, the IC chip mounting area 23 is disposed within the upper surface 102 of the corresponding ceramic capacitor 100, and the IC chip mounting area 24 is disposed within the upper surface 102 of the corresponding ceramic capacitor 101.

As shown in Fig. 1, the gap between the inner surface of the housing opening portion 90 and the side face 106 of the ceramic capacitor 100, 101 is filled with a filler 92 comprised of a polymer material (thermosetting resin, such as epoxy resin, in this embodiment). The filler 92 fixes each ceramic capacitor 100, 101 to the substrate core 11 as well as having a function of absorbing the deformation in the planar direction and the thickness direction of the ceramic capacitor 100, 101 and the substrate core 11 by its own elastic deformation. In addition, each ceramic capacitor 100, 101 assumes a generally square form in the plane view and includes a tapered portion having C 0.6 (R 0.6 mm) at each four corners thereof. Thus, when the filler 92 deforms due to a temperature variation, the stress concentration to the corners of each ceramic capacitor 100, 101 can be eased, thereby preventing the crack arising in the filler 92.

As shown in Figs. 1 - 4, the ceramic capacitor 100, 101 according to the present embodiment is so-called "a via array type ceramic capacitor". A ceramic sintered body 104 comprising the ceramic capacitor 100, 101 preferably has a thermal expansion coefficient, which is a mean value of the thermal expansion coefficient of the IC.chip 20, 21 and that of the built-up layer 31, 32, more preferably, the value near the thermal expansion coefficient of the IC chip 20, 21. In this embodiment, the thermal expansion coefficient of the ceramic sintered body 104 is about 8-12 ppm/°C, in detail, about 9. 5 ppm /°C. The thermal expansion coefficient of the ceramic sintered body 104 is defined as the average value of the measured value at between 30 °C and 250 degrees °C. Further, the ceramic sintered body 104 is a plate-like object having the upper surface 102 and the lower surface 103 (capacitor rear surface). Inaddition, the resin insulating layer 33 constituting the first built-up layer 31 is formed on the upper surface 102 of the ceramic sintered body 104, and the resin insulating layer 34 constituting the second built-up layer 32 is formed on the lower surface 103 of the ceramic sintered body 104. The ceramic sintered body 104 has a structure where a first internal electrode layer 141 and a second internal electrode layer 142 are alternately laminated by sandwiching a ceramic dielectric layer 105. The ceramic dielectric layer 105 is comprised of a sintered body of barium titanate, which is one of high permittivity ceramics, and functions as a dielectric (insulator) between the first internal electrode layer 141 and the second internal electrode layer 142. The first internal electrode layer 141 and the second internal electrode layer 142 are comprised mainly of nickel and are disposed alternately in the ceramic sintered body 104.

As shown in Figs. 2-4, a plurality of via holes 130 are formed in the ceramic sintered body 104 of the ceramic capacitor 100. These via holes 130 penetrate the ceramic sintered body 104 in the thickness direction and are disposed in a lattice pattern (an array form) over the whole surface. In each via hole 130, a plurality of via conductors 131, 132 comprised mainly of nickel are formed so as to communicate between the upper surface 102 and the lower surface 103 of the ceramic sintered body 104. Eachfirstviaconductor 131 for the power supply penetrates each first inner electrode layer 141 so that the first inner electrode layers 141 may be electrically connected to each other. Each first via conductor 132 for the ground penetrates each second inner electrode layer 142 so that the second inner electrode layers 142 may be electrically connected to each other. Each first via conductor 131 for the power supply and each first via conductor 132 for the ground are disposed in an array form as a whole. Notably, for explanatory purposes, the via conductor 131, 132 is illustrated by 3 x 3 in rows (or 5 x 5 in rows), however, the actual array has more rows.

As shown in Figs. 2-4, a plurality of first electrode terminals 111 for the power supply and a plurality of first electrode terminals 112 for the ground are formed on the upper surface 102 of the ceramic sintered body 104 of the ceramic capacitor 100 so as to protrude from the upper surface. Also, a plurality of first electrode terminals 121 for the power supply and a plurality of first electrode terminals 122 for the ground are formed on the lower surface 103 of the ceramic sintered body 104 of the ceramic capacitor 100 so as to protrude from the lower surface. The electrode terminal 111, 112 disposed at the upper surface 102 side is electrically connected to the via conductor 47. On the other hand, the electrode terminal 121, 122 disposed at the lower surface 103 side is electrically connected to an electrode (terminal) of a motherboard (not illustrated) through the via conductor 47, the conductor layer 42, the via conductor 43, the BGA pad 48 and the solder bump 49. Further, a generally center portion of the bottom surface of the electrode terminal 111, 112 is directly connected to the end face of the via conductor 131, 132 at the upper surface 102 side. The generally center portion of the bottom surface of the electrode terminal 121, 122 is directly connected to the end face of the via conductor 131, 132 at the lower surface 103 side. Therefore, the electrode terminal 111, 121 for the power supply is electrically conductive to the first via conductor 131 for the power supply and the first internal electrode layer 141, and the electrode terminal 112, 122 for the ground is electrically conductive to the first via conductor 132 for the ground and the second internal electrode layer 142, respectively.

Similarly, a plurality of via holes 130 are also formed in the ceramic sintered body 104 of the ceramic capacitor 101 as shown in Figs. 2 - 4. A plurality of via conductors 133, 134 comprised mainly of nickel is formed inside of each via hole 130 so as to communicate between the upper surface 102 and the lower surface 103 of the ceramic sintered body 104. Each second via conductor 133 for the power supply penetrates each first inner electrode layer 141 so that the first inner electrode layers 141 may be electrically connected to each other. Each second via conductor 134 for the ground penetrates each second inner electrode layer 142 so that the second inner electrode layers 142 may be electrically connected to each other. Each second via conductor 133 for the power supply and each second via conductor 134 for the ground are disposed in an array form as a whole. Notably, for explanatory purposes, the via conductor 133, 134 is illustrated by 3 x 3 in rows (or 5 x 5 in rows), however, the actual array has more rows.

Then, a plurality of second electrode terminals 113 for the power supply and a plurality of second electrode terminals 114 for the ground are formed on the upper surface 102 of the ceramic sintered body 104 of the ceramic capacitor 101 so as to protrude from the upper surface. Also, a plurality of second electrode terminals 123 for the power supply and a plurality of second electrode terminals 124 for the ground are formed on the lower surface 103 of the ceramic sintered body 104 of the ceramic capacitor 101 so as to protrude from the lower surface. The electrode terminal 113, 114 disposed at the upper surface 102 side is electrically connected to the via conductor 47. On the other hand, the electrode terminal 123, 124 disposed at the lower surface 103 side is electrically connected to an electrode (terminal) of a motherboard (not illustrated) through the via conductor 47, the conductor layer 42, the via conductor 43, the BGA pad 48 and the solder bump 49. Further, a generally center portion of the bottom surface of the electrode terminal 113, 114 is directly connected to the end face of the via conductor 133, 134 at the upper surface 102 side. The generally center portion of the bottom surface of the electrode terminal 123, 124 is directly connected to the end face of the via conductor 133, 134 at the lower surface 103 side. Therefore, the electrode terminal 113, 123 for the power supply is electrically conductive to the second via conductor 133 for the power supply and the first internal electrode layer 141, and the electrode terminal 114, 124 for the ground is electrically conductive to the second via conductor 134 for the ground and the second internal electrode layer 142, respectively.

As shown in Fig. 2, the electrode terminal 111, 112, 113, 114 is comprised mainly of nickel, and the surface thereof is entirely covered with a copper plating layer (not illustrated). Similarly, the electrode terminal 121, 122, 123, 124 is also comprised mainly of nickel, and the surface thereof is covered with the copper plating layer (not illustrated). In this embodiment, the diameter of the electrode terminals 111-114, 121-124 is about 500 µm, and the minimum pitch between the electrode terminals is about 580 µm.

When a voltage is applied to the first internal electrode layer 141 and the second internal electrode layer 142 through the electrode terminal 121, 122 (or the electrode terminal 123, 124) from the motherboard side, the positive charge will be accumulated in, for example, the first internal electrode layer 141, and negative charge will be accumulated in, for example, the second internal electrode layer 142. As a result, the ceramic capacitor 100, 101 functions as a capacitor. Moreover, in the ceramic capacitor 100, the first via conductor 131 for the power supply and the first via conductor 132 for the ground are al ternately adj acently disposed so that the current direction flowing through the first via conductor 131 for the power supply and the first via conductor 132 for the ground may reverse mutually. Similarly, in the ceramic capacitor 101, the second via conductor 133 for the power supply and the second via conductor 134 for the ground are alternately adjacently disposed so that the current direction flowing through the second via conductor 133 for the power supply and the second via conductor 134 for the ground may reverse mutually. As a result, reduction in the inductance is attained.

Further, a part of each first via conductor 131 for the power supply is electrically connected to the planar connection terminal 22 of the IC chip 20 through a first power supply conductive path formed by the first electrode terminal 111 for the power supply, the via conductor 47, the conductor layer 42, the via conductor 43, the terminal pad 44 and the solder bump 45. A part of first via conductor 132 for the ground is electrically connected to the planar connection terminal 22 of the IC chip 20 through a first ground conductive path formed by the first electrode terminal 112 for the ground, the via conductor 47, the conductor layer 42, the via conductor 43, the terminal pad 44 and the solder bump 45. Thereby, the power supply from the ceramic capacitor 100 to the IC chip 20 can be achieved.

Similarly, a part of each second via conductor 133 for the power supply is electrically connected to the planar connection terminal 22 of the IC chip 21 through a second power supply conductive path formed by the second electrode terminal 113 for the power supply, the via conductor 47, the conductor layer 42, the via conductor 43, the terminal pad 44 and the solder bump 45. A part of second via conductor 134 for the ground is electrically connected to the planar connection terminal 22 of the IC chip 21 through a second ground conductive path formed by the second electrode terminal 114 for the ground, the via conductor 47, the conductor layer 42, the via conductor 43, the terminal pad 44 and the solder bump 45. Thereby, the power supply from the ceramic capacitor 101 to the IC chip 21 can be achieved.

Thus, in the wiring board 10 according to the present embodiment, the IC chip 20, 21 has an individual power supply system. Therefore, each ceramic capacitor 100, 101 is not only physically independent, but is also electrically independent from each other.

Next, a method for manufacturing the wiring board according to the present embodiment will be described.

In a preparatory step, the substrate core 11 and the ceramic capacitor 100, 101 are produced in advance with a conventionally known method, respectively.

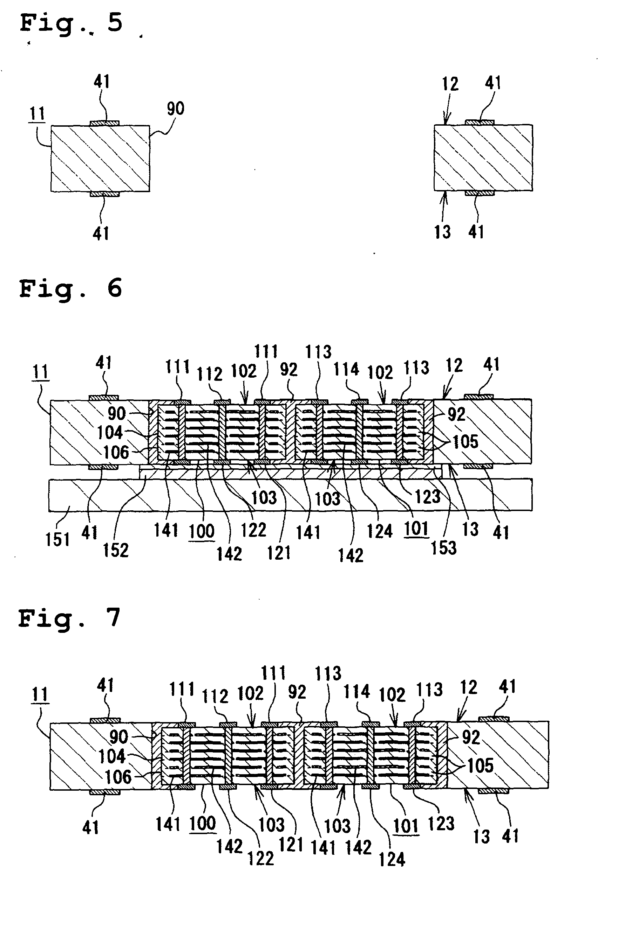

The substrate core 11 is produced as follows. First, a copper-clad laminated board in which a copper foil is laminated on both surfaces of a substrate having a size of 400mm (length) x 400mm (width) x 0.8mm (thickness) is prepared. In addition, the thickness of the substrate is preferably 0.2mm or more to 1.0mm or less. Next, a boring processing is performed to the copper-clad lamination using a routing machine to form a through-hole in advance in the predetermined location, which serves as the housing opening portion 90 (refer to Fig. 5). The through-hole serving as the housing opening portion 90 assumes a generally rectangular form cross-sectionally with a size of 14.0mm (lengthwise) x 30.0mm (crosswise) and a radius R 1.5mm at the four corners. Then, the copper foil laminated on both surfaces of the copper-clad lamination board is etched to form the pattern of the conductor layer 41 by, for example, a subtractive method. In detail, after performing the electroless copper plating, the electrolytic copper plating is applied thereto employing the electroless copper plating layer as a common electrode. Subsequently, a dry film is laminated on thus-plated surface and subjected to an exposure and a development to thereby form predetermined pattern. In this process, unnecessary electrolytic copper plating layer, electroless copper plating layer and copper foil are removed by etching. Then, the dry film is peeled to complete the substrate core 11.

The ceramic capacitor 100, 101 is produced as follows. A ceramic green sheet comprised of ceramics is produced, and then a nickel paste for an internal electrode layer is screen-printed on the green sheet and dried. Accordingly, a first internal electrode portion serving as the first internal electrode layer 141 and a second internal electrode portion serving as the second internal electrode layer 142 are formed. Next, the green sheet in which the first internal electrode portion is formed and the green sheet in which the second internal electrode portion is formed are alternately laminated and pressed in the laminated direction to thereby integrate the green sheets. Then, a green sheet laminated body is formed.

Furthermore, a plurality of via holes 130 are formed in the green sheet laminated body using a laser processing machine, and a nickel paste for via conductor is filled in each via hole 130 using a press-fit filling equipment (not illustrated). Next, a paste is printed on the upper surface of the green sheet laminated body to form the first electrode terminal 111 for the power supply and the first electrode terminal 112 for the ground (or the second electrode terminal 113 for the power supply and the second electrode terminal 114 for the ground) so as to cover the upper end face of each conductor portion at the upper side of the green sheet laminated body. Moreover, the paste is printed on the lower surface of the green sheet laminated body to form the first electrode terminal 121 for the power supply and the first electrode terminal 122 for the ground (or the second electrode terminal 123 for the power supply and the second electrode terminal 124 for the ground) so as to cover the lower end face of each conductor portion at the lower side of the green sheet laminated body.

Subsequently, the green sheet laminated body is dried so that a surface terminal portion may be solidified to some extent. Next, the green sheet laminated body is degreased and subjected to firing at a predetermined temperature for a predetermined time. As a result, barium titanate and nickel contained in the paste are simultaneouslysintered, thereby forming the ceramic sintered body 104.

Next, the electroless copper plating (about 10 µm in thickness) is applied to each electrode terminal 111, 112, 121, 122 (or each electrode terminal 113, 114, 123, 124) which are included in the ceramic sintered body 104. As a result, the copper plating layer is formed on each electrode terminal 111, 112, 121, 122 (or each electrode terminal 113, 114, 123, 124), thereby completing the ceramic capacitor 100 (or the ceramic capacitor 101) . In addition, instead of applying the electroless copper plating, the electrolytic copper plating may be applied.

In a subsequent fixation step, 2 pieces of ceramic capacitors 100, 101 are accommodated in the housing opening portion 90 using a mounting device (made by Yamaha Motor Co., Ltd.) (refer to Fig. 6). At this time, an adhesive tape 152, which can be peeled, is employed to seal the lower surface 13 side opening of the housing opening portion 90. The adhesive tape 152 is supported by a support board 151. Each ceramic capacitor 100, 101 is stuck on an adhesive face 153 of the adhesive tape 152 to be temporarily fixed.

In this state, the gap between the inner surface of the housing opening portion 90 and the side face 106 of the ceramic capacitor 100, 101, and the region between the adjacent ceramic capacitor 100, 101 is filled with a filler 92 made of thermosetting resin (underfill material, made by Namix Co., Ltd.) using a dispenser device (made by Asymtek). Then, the filler 92 is hardened in a heat treatment to fix the ceramic capacitor 100, 101 to the housing opening portion 90. Then, the adhesive tape 152 is peeled at this time.

Subsequently, a built-up layer formation step is conducted. In the built-up layer formation step, the first built-up layer 31 is formed on the upper surface 12 and the upper surface 102, and the second built-up layer 32 is formed on the lower surface 13 and the lower surface 103, based on the conventionally known method. As a result, the wiring board 10 comprised of the substrate core 11, the built-up layer 31, 32 is completed. In detail, while laminating a photosensitive epoxy resin on the upper surface 12 and the upper surface 102, the photosensitive epoxy resin is laminated on the lower surface 13 and the lower surface 103. Then, an exposure and development are performed on thus-upper and lower surfaces to forma resin insulating layer 33, 34 of the first layer, respectively. The resin insulating layer 33, 34 has a blind via in a location where the via conductor 47 is formed. Further, a boring processing is performed using a YAG laser or a carbon dioxide laser to form a through-hole penetrating substrate core 11 and the resin insulating layer 33, 34. Then, after forming a through-hole conductor 16 by performing electroless copper plating and electrolytic copper plating in accordance with the conventionally known method, a plugging body 17 is filled in the through-hole conductor 16. Subsequently, the electrolytic copper plating is performed in accordance with the conventionally known method (e.g., semiadditive method) so as to form the via conductor 47 inside of the blind via, as well as forming the conductor layer 42 serving as a second layer on the resin insulating layer 33, 34 serving as the first layer.

Next, the photosensitive epoxy resin is laminated on the resin insulating layer 33, 34 serving as the first layer, and the exposure and development thereof is performed to form the resin insulating layer 35, 36 of a second layer which has a blind via in the location where the via conductor 43 is formed. Then, the electrolytic copper plating is applied in accordance with the conventionally known method to form the via conductor 43 inside of the blind via and to form a terminal pad 44 on the resin insulating layer 35 serving as the second layer and a pad 48 for BGA is formed on the resin insulating layer 36 serving as the second layer.

Subsequently, a solder resist 37, 38 are formed on the resin insulating layer 35, 36 serving as the second layer by applying the photosensitive epoxy resin and curing thereof. Next, the exposure and development are performed in the state where the predetermined mask is disposed to pattern-print an opening 40, 46 on the solder resist 37, 38. Further, a solder bump 45 is formed on the terminal pad 44, and a solder bump 49 is formed on the pad 48 for BGA. As a result, the wiring board 10 comprised of the substrate core 11 and the built-up layer 31, 32 is completed.

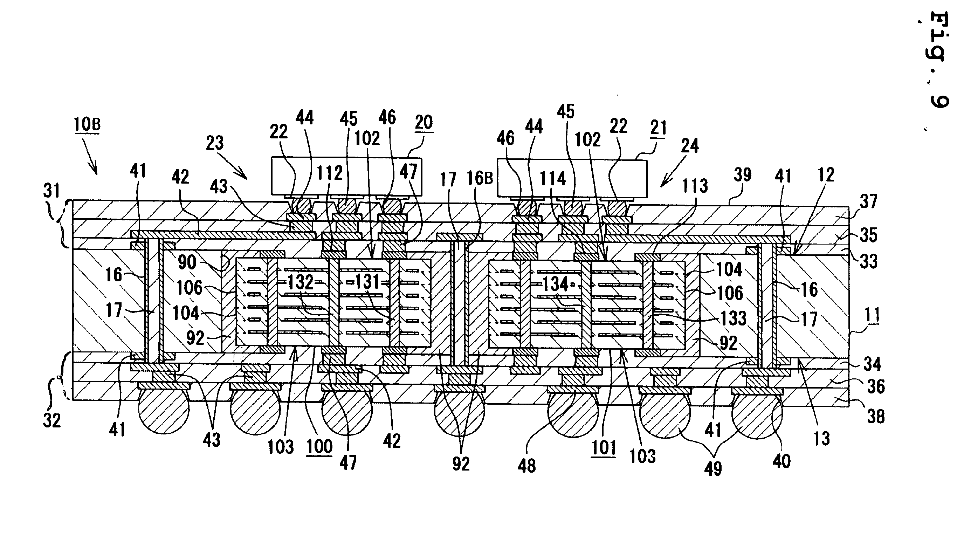

Therefore, according to the present embodiment, the following effects can be attained.
(1) In the wiring board 10 according to the present embodiment, two locations for the IC chip mounting areas 23, 24 are provided in the first built-up layer 31, and, in the substrate core 11, two pieces of ceramic capacitors 100, 101 are disposed in each are a corresponding to the IC chip mounting area 23, 24, respectively. Thus, for example, a conductor body, such as a through-hole conductor 16B (refer to Fig. 9) may be formed in the area formed between the ceramic capacitors 100, 101, resulting in effectively utilizing the inside area of the wiring board 10. Even thought the wiring board 10 has a so-called multi-microprocessor structure where two pieces of IC chips 20, 21 are mounted, the conductor layer for electrically connecting the top and rear surfaces of the substrate core 11 can be formed, thereby increasing in design flexibility. As a result, reduction in the overall size of the wiring board 10 and cost are facilitated.
   Further, even if it is a case where the power supply system of each IC chip 20, 21 cannot be shared and the individual power supply system for each IC chip 20, 21 is necessary, each IC chip 20, 21 can fully operate because two pieces of ceramic capacitors 100, 101 are electrically connected to the IC chip mounting areas 23, 24, respectively. Therefore, when adopting the multi-microprocessor structure similar to this embodiment, the advantages of such structure can be fully realized.
(2) In this embodiment, since the IC chip mounting areas 23, 24 in the first built-up layer 31 are located right above the ceramic capacitors 100, 101, respectively, each IC chip mounting areas 23, 24 is supported by the ceramic capacitor 100, 101 which has high rigidity and a small coefficient of thermal expansion. Therefore, in the IC chip mounting areas 23, 24, the IC chips 20, 21, which are mounted on the IC chip mounting are as 23, 24, respectively, are more stably supported because the first built-up layer 31 is unlikely to deform. Thus, a crack and faulty connection of the IC chips 20, 21 resulting from great heat stress can be prevented. Therefore, a large-scale IC chip with the size of 10 mm x 10mm or more, which tends to be greatly influenced by thermal stress and has a high calorific power, or an IC chip of low-k (lower dielectric constant), which is fragile and also tends to be greatly influenced by thermal stress, can be employed as the IC chips 20, 21.
   Further, since the wiring board 10 according to the present embodiment has two pieces of ceramic capacitors 100, 101, power supply can be successfully implemented to each IC chips 20, 21 by removing a noise at each ceramic capacitor 100, 101. Furthermore, each IC chip 20, 21 is mounted on each IC chip mounting area 23, 24, respectively and disposed right above each ceramic capacitor 100, 101. Thereby, the distance of the electrical connection path (capacitor connection wiring), which electrically connects between each IC chip 20, 21 and each ceramic capacitor 100, 101 can be the shortest. Therefore, the power supply to each IC chip 20, 21 is smoothly performed. As a result, the noise arising between the IC chip 20, 21 and each ceramic capacitor 100, 101 can be significantly reduced, and high reliability is attained without producing any fault, such as malfunction.
(3) In the paragraph [0063] of Japanese Patent Application Laid-Open (kokai) No. 2002-43754, the prior art in which a plurality of chip capacitors are embedded in the substrate core is disclosed. However, even though plural chip capacitors are provided, high functioning features attained by a stabilization of the power supply or the like are unlikely to be obtained. Further, since the upper surface area of the chip capacitor is much smaller than the IC chip mounting area, the chip capacitor cannot serve as a support body for the IC chip 20, 21.
   On the other hand, since a via arrayed type ceramic capacitor 100, 101 with large electric capacity instead of a mere chip capacitor is used in this embodiment, it is easy to attain high functioning features. The dimension of the IC chip mounting area 23, 24 is smaller than that of the upper surface 102 of the corresponding ceramic capacitor 100, 101 in this embodiment. In other words, the ceramic capacitor 100, 101 having a larger area than the IC chip mounting area 23, 24 is used. Further, when looking from the thickness direction, the IC chip mounting area 23, 24 are located in the upper surface 102 of the ceramic capacitor 100, 101. Therefore, the ceramic capacitor 100, 101 can operate as a support body of the IC chip 20, 21.
(4) For example, a chip capacitor can be used instead of the ceramic capacitor 100, 101 and is disposed at the rear side (a top surface side of a second built-up layer 32) of the IC chip 20, 21 in the wiring board 10. For example, inductance of the chip capacitor becomes 7.2pH and that of the electric path for connecting the chip capacitor and the IC chip 20, 21 becomes 2.8pH. In total, the inductance becomes 10.0pH, which is relatively a large value.
   On the other hand, the ceramic capacitor 100, 101 having a lower inductance (1.2pH) than that of the chip capacitor is used in this embodiment. Further, since the ceramic capacitor 100, 101 is embedded in the substrate core 11, the distance of the electric path for connecting the ceramic capacitor 100, 101 and the IC chip 20, 21 is shorter than that of the electric path for connecting the chip capacitor and the IC chip 20, 21. Therefore, the inductance of theelectricpathbecomesas lowas 0.6pH. Intotal, the inductance becomes 1.8pH and an inductance component can be reduced rather than the case where the chip capacitor is used. Thus, the power can be smoothly supplied, and a generation of noise can be prevented.
(5) In the ceramic capacitor 100 according to this embodiment, a plurality of first via conductors 131 for the power supply and a plurality of first via conductors 132 for the ground are disposed in an array form as a whole. Similarly, in the ceramic capacitor 101 according to this embodiment, a plurality of second via conductors 133 for the power supply and a plurality of second via conductors 134 for the ground are disposed in an array form as a whole. That is, the ceramic capacitor 100, 101 is a via-arrayed-type capacitor. Therefore, a reduction in size of the ceramic capacitor 100, 101 is facilitated, resulting in a reduction in the overall size of the wiring board 10. Furthermore, despite its compact size, high electric capacity may be relatively easily secured, thereby establishing more stable power supply.

Hereafter, a second embodiment for carrying out a wiring board according to the present invention will be described in detail with reference to the drawings.

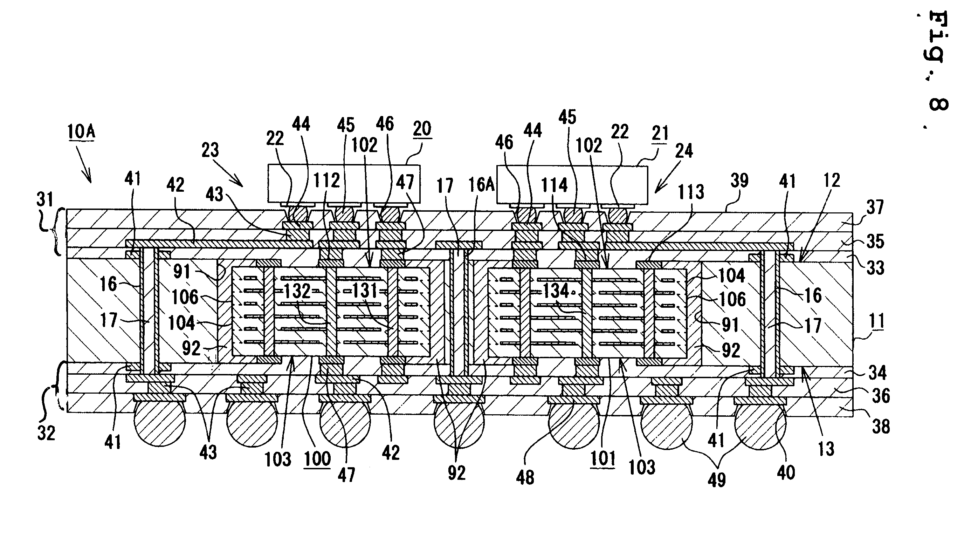

As shown in Fig. 8, a wiring board 10A according to the present embodiment includes two housing opening portions 91 which open at the upper surface 12 of the substrate core 11. Each ceramic capacitor 100, 101 is accommodated in each housing opening portion 91, respectively, in the state where the upper surface 12 and the upper surface 102 are turned to the same side. In addition to the through-hole conductor 16 described in the first embodiment, the substrate core 11 includes a through-hole conductor 16A (conductor portion) disposed in an area formed between the adjoining housing opening portions 91. The inside of the through-hole conductor 16, 16A is filled with, for example, a plugging body 17 such as an epoxy resin. The upper end of the through-hole conductor 16, 16A is electrically connected to the conductor layer 42 formed on the resin insulating layer 33 of the first built-up layer 31, and the lower end of the through-hole conductor 16, 16A is electrically connected to the conductor layer 42 formed on the resin insulating layer 34 of the second built-up layer 32. That is, the through-hole conductor 16, 16A has a function to electrically connect the first built-up layer 31 and the second built-up layer 32. The through-hole conductor 16A formed between the adjoining housing opening portions 91 is formed simultaneously with other through-hole conductors 16 by means of the same method as that of the through-hole conductor 16 of the first embodiment.

Therefore, in this embodiment, the space for forming the through-hole conductor 16A can be easily secured in the area formed between the adjoining ceramic capacitors 100, 101. As a result, even though the multi-microprocessor structure in which two pieces of IC chips 20, 21 are mounted is adopted, a wiring of the conductor layer used for electrically connecting the top and rear surfaces of the substrate core 11 can be formed easily.

Further, by forming the through-hole conductor 16A in the area formed between the adjoining ceramic capacitors 100, 101, any conductor for signals is not necessarily formed in the ceramic capacitor 100, 101 or the substrate core 11. Therefore, the miniaturization of the ceramic capacitor 100, 101 or the substrate core 11 may be facilitated. Furthermore, the miniaturization of ceramic capacitor 100, 101 contributes to an easy formation of the through-hole conductor 16A because the enough space for forming the through-hole conductor 16A can be secured.

In addition, each embodiment of the present invention may be modified as follows.

In the first embodiment, a conductor portion, such as a through-hole conductor 16B (see the wiring board 10B in Fig. 9) may be formed in the filler 92 which fills the area formed between the adjoining ceramic capacitors 100, 101. This structure facilitates the easy wiring of the conductor layer for electrically connecting the rear and top surfaces of the substrate core 11. In addition, the through-hole conductor 16B in the filler 92 is formedasfollows. Thatis,athrough-holepenetratingthesubstrate core 11 and the resin insulating layer 33, 34 and a through-hole penetrating the filler 92 are formed simultaneously by a laser boring processing. Then, an electroless copper plating and an electrolytic copper plating are applied by the conventionally known method so as to form the through-hole conductor 16B in the filler 92 which fills the area formed between the ceramic capacitor 100, 101.

The housing opening portion 90, 91 of each embodiment described above is a through-hole portion which opens at the upper surface 12 and the lower surface 13 of the substrate core 11. However, the housing opening portion 90, 91 may be a bottomed concave portion (non-through-hole portion), which opens only at the upper surface 12 of the substrate core 11.

A wiring pattern (inner layer pattern) may be formed in the substrate core 11 according to each embodiment described above. With this structure, a complicated electric circuit can be formed inside of the wiring board 10, thereby facilitating much more advanced features of the wiring board 10. Further, the substrate core 11 may be formed in such a manner that a thin insulating layer is laminated on the core.

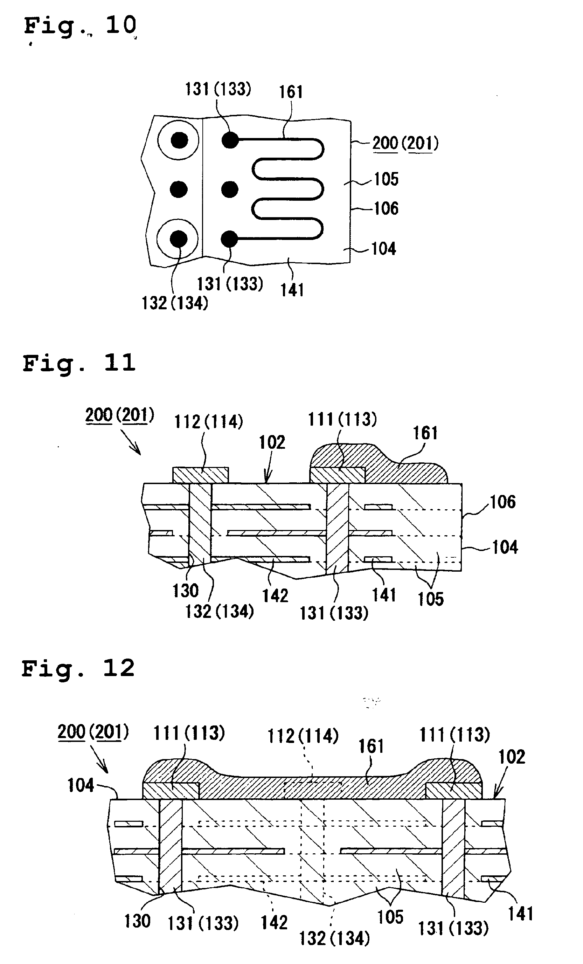

As shown in Figs. 10 - 12, a resistive element 161 may be formed on an upper surface 102 or the like of a ceramic capacitor 200, 201. For example, the resistive element 161 electrically connects a first electrode terminal 111 for the power supply (second electrode terminal 113 for the power supply) and the other first electrode terminal 111 for the power supply (second electrode terminal 113 for the power supply). Notably, the resistive element 161 is comprised of ceramics having a higher resistance than that of a material constituting the electrode terminal 111, 113 for the power supply, the first inner electrode layer 141 and the second inner electrode layer 142. The suitable resistive element 161 is formed such that, for example, after completion of the ceramic capacitor 200, 201, a ceramic paste is applied to the upper surface 102 side and fired for a predetermined duration, and then adjusting resistance value or the like by removing an unnecessary portion.

With this structure, a different electrical potential can be established in, for example, the same ceramic capacitor 200, 201, thereby facilitating the advanced features of the wiring board 10. When no resistive element is formed in the ceramic capacitor 200, 201, the resistive element is necessarily embedded in a location in the substrate core 11 other than in the ceramic capacitor 200, 201, or formed at the built-up layer 31, 32 side.

A plurality of dummy-via electrodes (ground via electrode) may be disposed between the ceramic capacitors 100, 101. With this structure, the noise caused by interference between the ceramic capacitor 100 and the ceramic capacitor 101 can be reduced. Specifically, when the ceramic capacitor 100, 101 contains a large capacity portion and the small capacity portion whose capacity is smaller than the large capacity portion, it is preferable to provide plural dummy-via electrodes (groundviaelectrodes) between the large capacity portion and the small capacity portion. As a result, the noise generated in the small capacity portion, which tends to receive interference of the large capacity portion, can be reduced. Further, in consideration of heat dissipation, a plurality of dummy-via electrodes (ground via electrodes) may be disposed in a location surrounding the ceramic capacitor 100, 101.

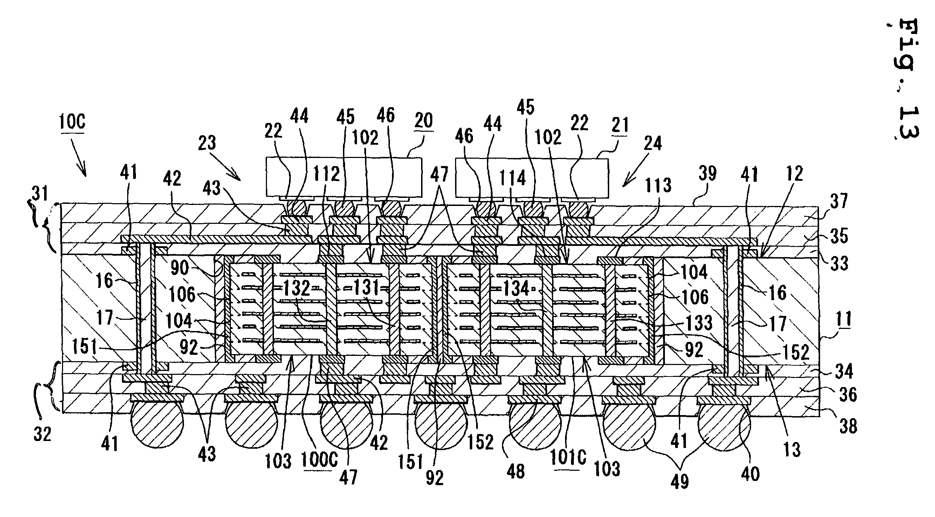

Like a wiring board 10C according to another embodiment shown in Fig. 13, a side face dummy electrode 151, 152 may be formed in a face (i.e., side face 106) other than the upper surface 102 and the lower surface 103 of a ceramic capacitor 100C, 101C. Similar to the above embodiment, this structure also contributes to a reduction in noise caused by interference between the ceramic capacitors 100C, 101C. The side face dummy electrode 151, 152 shown in Fig. 13 may be a conductor which is not electrically connected to any conductor layers. However, preferably, the side face dummy electrode 151, 152 is electrically connected to, for example, the conductor layer for the ground in the built-up layer 31, 32. According to this structure, the shielding effectiveness can be improved. Notably, such side face dummy electrode 151, 152 is comprised of, for example, the same metal material as that of the electrode terminal provided in the ceramic capacitor 100C, 101C.

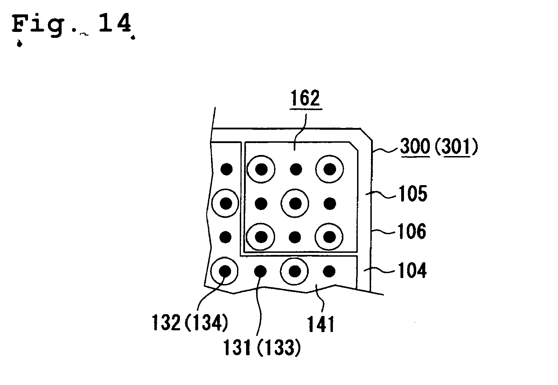

As shown in Fig. 14, a capacitor portion 162 of a separate system (for the power supply to I/O or the like) other than for the IC chip 20, 21 may be formed in a part of a ceramic capacitor 300, 301. This structure allows the wiring board 10 to have more advanced features.

Next, the technical ideas obtained by the embodiments mentioned above will be described below.
(1) A wiring board comprising: a substrate core including a core main surface and a core rear surface; a plurality of ceramic capacitors having a capacitor main surface and a structure where a first inner electrode layer and a second inner electrode layer arealternatelylaminatedbysandwichingaceramicdielectriclayer, and further including a plurality of via conductors for the power supply which electrically connect each first inner electrode layer and a plurality of via conductors for the ground which electrically connect each second inner electrode layer, wherein said plural via conductors for the power supply and said plural via conductors for the ground are disposed in an array form and embedded in said substrate core in the state where said core main surface and said capacitor main surface are turned to the same side; and a built-up layer having a structure where an interlayer insulating layer and a conductor layer are alternately laminated on said core main surface and said capacitor main surface, and providing a plurality of semiconductor integrated circuit element mounting areas in various locations on a surface of said built-up layer, and wherein, in said substrate core, said plural ceramic capacitors are disposed, respectively, in areas corresponding to said plural semiconductor integrated circuit element mounting areas.
(2) The wiring board according to the paragraph (1) comprising: an electrode terminal for the power supply located at an end of said plural via conductors for the power supply of said capacitor main surface side; and an electrode terminal for the ground located at an end of said plural via conductors for the ground of said capacitor main surface side.
(3) The wiring board according to the paragraph (1) or (2), wherein said plural via conductors for the power supply and said plural via conductors for the ground are used for communicating said capacitor main surface and said capacitor rear surface. Therefore, according to the technical idea (3), the miniaturization of the ceramic capacitor tends to be facilitated, thereby contributing to a reduction in the overall size of the wiring board.
(4) A package having a multi-microprocessor structure, comprising: a substrate core including a core main surface and a core rear surface; a plurality of ceramic capacitors having a capacitor main surface and a structure where a first inner electrode layer and a second inner electrode layer are alternately laminated by sandwiching a ceramic dielectric layer, wherein said ceramic capacitor is embedded in said substrate core in the state where said core main surface and said capacitor main surface are turned to the same side; a built-up layer having a structure where an interlayer insulating layer and a conductor layer are alternately laminated on said core main surface and said capacitor main surface, and providing a plurality of semiconductor integrated circuit element mounting areas in the various locations on a surface of saidbuilt-up layer; and a plurality of semiconductor integrated circuit elements mounted on said plural semiconductor integrated circuit element mounting areas, and wherein said plural semiconductor integrated circuit elements and said plural ceramic capacitors are electrically connected, respectively through a conductor portion of said built-up layer, wherein, in said substrate core, said plural ceramic capacitors are disposed, respectively in areas corresponding to said plural semiconductor integrated circuit element mounting areas.
(5) A wiring board, comprising: a substrate core including a core main surface and a core rear surface; a plurality of ceramic capacitors having a capacitor main surface and a structure where a first inner electrode layer and a second inner electrode layer are alternately laminated by sandwiching a ceramic dielectric layer, wherein said ceramic capacitor is embedded in said substrate core in the state where said core main surface and said capacitor main surface are turned to the same side; a first built-up layer having a structure where an interlayer insulating layer and a conductor layer are alternately laminated on said core main surface and said capacitor main surface, and providing a plurality of semiconductor integrated circuit element mounting areas in the various locations on a surface of said built-up layer; and a second built-up layer having a structure where an interlayer insulating layer and a conductor layer are alternately laminated on said core main surface and said capacitor main surface, and wherein, in said substrate core, said plural ceramic capacitors are disposed, respectively in areas corresponding to said plural semiconductor integrated circuit element mounting areas.
(6) A wiring board, comprising: a substrate core including a core main surface and a core rear surface; a plurality of ceramic capacitors having a capacitor main surface and a structure where a first inner electrode layer and a second inner electrode layer arealternatelylaminatedbysandwichingaceramicdielectriclayer, wherein said ceramic capacitor is embedded in said substrate core in the state where said core main surface and said capacitor main surface are turned to the same side; and a built-up layer having a structure where an interlayer insulating layer and a conductor layer are alternately laminated on said core main surface and said capacitor main surface, and providing a plurality of semiconductor integrated circuit element mounting areas in the various locations on a surface of said built-up layer, and wherein said plural ceramic capacitor sare disposed in the locations, respectively, which over lap said plural semiconductor integrated circuit element mounting areas when looking from the thickness direction of the capacitor.
(7) A wiring board, comprising: a substrate core including a core main surface and a core rear surface; a plurality of ceramic capacitors having a capacitor main surface and a structure where a first inner electrode layer and a second inner electrode layer are alternately laminated by sandwiching a ceramic dielectric layer, wherein said ceramic capacitor is embedded in said substrate core in the state where said core main surface and said capacitor main surface are turned to the same side; and a built-up layer having a structure where an interlayer insulating layer and a conductor layer are alternately laminated on said core main surface and said capacitor main surface, and providing a plurality of semiconductor integrated circuit element mounting areas in the various locations on a surface of said built-up layer, and wherein said plural ceramic capacitors are accommodated, respectively in inner areas of said substrate core, which are situated generally right under said plural semiconductor integrated circuit element mounting areas.

### Description of Reference Numerals

10, 10A, 10B, 10C --wiring board
11 -- substrate core
12 -- upper surface as a core main surface
13 -- lower surface as a core rear surface
16, 16A, 16B - through-hole conductor as a conductor portion
23, 24 -- IC chip mounting area as a semiconductor integrated circuit element mounting area
31 - first built-up layer as a built-up layer
33,34,35,36--resin insulating layer as an interlayer insulating layer
39 -- surface of built-up layer
42 -- conductor layer
90, 91 -- housing opening portion
92 -- filler
100, 101, 100C, 101C, 200, 201, 300, 301 -- ceramic capacitor
102 -- upper surface as a capacitor main surface
103 -- lower surface as a capacitor rear surface
105 -- ceramic dielectric layer
141 -- first inner electrode layer
142 -- second inner electrode layer
161 -- resistive element

## Claims

1. A wiring board, comprising:
a substrate core (11) including a core main surface (12) and a core rear surface (13);
a plurality of ceramic capacitors (100, 101, 100C, 101C, 200, 201, 300, 301) having a capacitor main surface (102) and a structure where a first inner electrode layer (141) and a second inner electrode layer (142) are alternately laminated by sandwiching a ceramic dielectric layer (105), wherein said ceramic capacitor (100, 101, 100C, 101C, 200, 201, 300, 301) is embedded in said substrate core (11) in the state where said core main surface (12) and said capacitor main surface (102) are turned to the same side; and
a built-up layer (31) having a structure where an interlayer insulating layer (33, 35) and a conductor layer (42) are alternately laminated on said core main surface (12) and said capacitor main surface (102), and including a plurality of semiconductor integrated circuit element mounting areas (23, 24) in various locations on a surface (39) of said built-up layer (31), and
wherein said plural ceramic capacitors (100, 101, 100C, 101C, 200, 201, 300, 301) are disposed in areas of said substrate core (11), which correspond to said plural semiconductor integrated circuit element mounting areas (23, 24).

2. A wiring board according to claim 1,
wherein said substrate core (11) has a plurality of housing opening portions (91) therein which open at said core main surface (12), and
wherein said ceramic capacitors (100, 101, 100C, 101C, 200, 201, 300, 301) are accommodated in said plural housing opening portions (91), respectively, in the state where said core main surface (12) and said capacitor main surface (102) are turned to the same side.

3. A wiring board according to claim 2,
wherein said substrate core (11) includesaconductorportion (16A), which electrically connects said core main surface (12) side and said core rear surface (13) side, in an area formed between said adjoining housing opening portions (91).

4. A wiring board according to claim 1,
wherein said substrate core (11) includes a housing opening portion (90) therein which opens at said core main surface (12), and
wherein said ceramic capacitor (100, 101) is accommodated plurally in said housing opening portion (90) in the state where said core main surface (12) and said capacitor main surface (102) are turned to the same side.

5. A wiring board according to claim 4,
wherein a filler (92) which fills an area formed between said adjoining ceramic capacitors (100, 101, 100C, 101C, 200, 201, 300, 301) is provided, and a conductor portion (16B), which electrically connects said core main surface (12) side and said core rear surface (13) side, is formed in said filler (92).

6. A wiring board according to any one of claims 1 to 5,
wherein a dimension of said semiconductor integrated circuit element mounting area (23, 24) is established so as to be equal to or smaller than the dimension of said capacitor main surface (102) of the corresponding ceramic capacitor (100, 101, 100C, 101C, 200, 201, 300, 301), and
wherein said semiconductor integrated circuit element mounting area (23, 24) is preferably located within said capacitor main surface (102) of the corresponding ceramic capacitor (100, 101, 100C, 101C, 200, 201, 300, 301), when looking from the thickness direction of said ceramic capacitor (100, 101, 100C, 101C, 200, 201, 300, 301).

7. A wiring board according to any one of claims 1 to 6,
wherein a dimension of said semiconductor integrated circuit element mounting area (23, 24) is 50% or more to 90% or less of a dimension of said capacitor main surface (102) of the corresponding ceramic capacitor (100, 101, 100C, 101C, 200, 201, 300, 301).

8. A wiring board according to any one of claims 1 to 7,
wherein said built-up layer (31) is a first built-up layer (31) and
wherein said wiring board includes a second built-up layer (32) having a structure where an interlayer insulating layer (34, 36) and a conductor layer (42) is alternately laminated on said core rear surface (13) and said capacitor rear surface (103).

9. A wiring board according to any one of claims 1 to 8,
wherein at least one of said ceramic capacitors (100, 101, 100C, 101C, 200, 201, 300, 301) includes a side face dummy electrode (151, 152) which facing to said adjoining ceramic capacitor (100, 101, 100C, 101C, 200, 201, 300, 301).

10. A wiring board according to claim 9,
wherein said side face dummy electrode (151, 152) is electrically connected to a conductor layer for the ground in a built-up layer (31).
